# EUROPÄISCHE PATENTSCHRIFT

(11) **EP 1 474 356 B1**
(45) Veröffentlichungstag und Bekanntmachung des Hinweises auf die Patenterteilung: **01.06.2005**
(21) Anmeldenummer: 03704457.5
(22) Anmeldetag: 23.01.2003
(51) Int. Cl.: B81B 7/00

(54) **VERFAHREN ZUR ERZEUGUNG EINER ABDECKUNG, VERFAHREN ZUM HERSTELLEN EINES GEHÄUSTEN BAUELEMENTS**
METHOD FOR THE PRODUCTION OF A COVER, METHOD FOR THE PRODUCTION OF A CASED COMPONENT
PROCEDE POUR REALISER UNE COUVERTURE, PROCEDE POUR FABRIQUER UN COMPOSANT DANS SON BOITIER

(30) Priorität: 19.02.2002 DE 10206919
(43) Veröffentlichungstag der Anmeldung: 10.11.2004
(73) Patentinhaber: Infineon Technologies AG, 81669 München (DE)
(72) Erfinder: AIGNER, Robert, 82008 Unterhaching (DE); FRANOSCH, Martin, 81739 München (DE); MECKES, Andreas, 81735 München (DE); OPPERMANN, Klaus-Guenter, 83607 Holzkirchen (DE); STRASSER, Marc, 81667 München (DE)
(74) Vertreter: Zimmermann, Tankred Klaus
(86) Internationale Anmeldenummer: PCT/EP2003/000691
(87) Internationale Veröffentlichungsnummer: WO 2003/070624

(56) Entgegenhaltungen:
- EP-A- 0 794 616
- EP-A- 0 805 552
- WO-A-01/59827
- WO-A-95/30276
- US-A- 5 668 033
- US-A1- 2001 011 857

## Beschreibung

Die vorliegende Erfindung bezieht sich auf gehäuste Bauelemente und insbesondere auf gehäuste Bauelemente, die mechanisch empfindliche Komponenten enthalten. Eine mechanisch empfindliche Komponente bzw. ein aktiver Bereich ist beispielsweise ein SAWoder BAW-Filter oder ein mikromechanisches Element.

In zunehmendem Maße spielen mikromechanische Bauelemente eine größere Rolle, wenn insbesondere an Drehratensensoren, Beschleunigungssensoren, etc. gedacht wird. Hier ist ein mechanisch aktives Teil, wie z. B. eine abhängig von der Beschleunigung auslenkbare Masse oder ein in eine Anregungsschwingung versetzbarer Schwinger bei einem Drehratensensor, oder allgemein ein Sensor oder Aktor zusammen mit einer integrierten Schaltung zum Ansteuern und/oder Auswerten des Bauelements gehäust. Auch andere Elemente, deren Charakteristika durch ein Vergußgehäuse beeinträchtigt werden, wie z. B. Bulk-Acoustic-Wave-Filter (BAW-Filter) oder Surface-Acoustic-Wave-Filter (SAW-Filter), sind entweder alleine oder zusammen mit einer integrierten Schaltung zum Ansteuern oder Auslesen gehäust.

Übliche Häusungskonzepte, wie z. B. ein Eingießen oder Moulding in Kunststoff oder Harz ist dahingehend nachteilhaft, da die mechanischen Eigenschaften mechanisch empfindlicher Teile beeinträchtigt werden können, oder da, wie im Falle von BAW- oder SAW-Filtern auch das Material an der Oberfläche der BAW-Resonatoren Einfluß auf die Charakteristika des Filters hat.

Zum Schutz mechanischer Strukturen wurden bisher Wafer mit entsprechenden Strukturen, d. h. Filtern, Resonatoren, Sensoren oder Aktoren, etc., mit einem zweiten Wafer gebondet, in den an den Stellen der Struktur Gruben und Löcher geätzt sind, so daß die Gruben des zweiten Wafers Hohlräume über den empfindlichen Strukturen des ersten Wafers bildet, und die Löcher im zweiten Wafer (Deckelwafer) Kontaktpads des ersten Wafers zugänglich machen. Dadurch sind die empfindlichen Strukturen geschützt. Alternativ werden auch Keramikgehäuse eingesetzt, welche jedoch teuer sind.

Die Aufgabe der vorliegenden Erfindung besteht darin, ein kosteneffektives und dennoch sicheres Konzept zum Häusen von sensiblen Bauelementen zu schaffen.

Diese Aufgabe wird durch ein Verfahren zur Erzeugung einer Abdeckung nach Anspruch 1 gelöst.

Der vorliegenden Erfindung liegt die Erkenntnis zugrunde, daß eine Abdeckung für ein in irgendeiner Weise sensibles Bauelement kostengünstig und kompatibel mit dem sonstigen Herstellungsprozeß hergestellt werden kann, wenn statt der einstückigen Ausführung eine zweistückige Abdeckung unter Verwendung einer Rahmenstruktur auf dem Systemwafer, auf dem auch die zu schützenden Bauelemente angeordnet sind, und einer Deckelstruktur gebildet wird. Die Deckelstruktur wird unter Verwendung eines Trägerwafers auf die Rahmenstruktur aufgesetzt, wonach der Trägerwafer unter Verwendung einer Opferschicht entfernt wird und die Deckelstruktur zurückbleibt. Zur Verbindung der Deckelstruktur und der Rahmenstruktur kann beispielsweise eine Klebstoffschicht eingesetzt werden.

Als Material für die Rahmenstruktur und die Deckelstruktur wird ein photostrukturierbares Epoxidharzmaterial und insbesondere ein relativ dickes Epoxidharz verwendet. Dieses Epoxidharz, das in flüssigem Zustand auf den Wafer aufgeschleudert wird ist im ausgehärteten Zustand stabil und gut verarbeitbar, kann zudem gut geklebt werden und ist im Vergleich zu einem Silizium-Wafer oder einem Quarz-Wafer erheblich preisgünstiger. Da das Epoxidharz für die Deckelstruktur mittels einer Opferschicht an einem Trägerwafer angeordnet wird, hat es ferner den Vorteil, daß die Opferschicht selektiv gelöst werden kann, so daß nur die Deckelschicht auf dem Systemwafer und insbesondere auf der Rahmenstruktur des Systemwafers zurückbleibt. Die selektive Lösbarkeit hat ferner den Vorteil, daß der Trägerwafer nicht durch den Lösungsprozeß der Opferschicht angegriffen wird und somit wiederverwendet werden kann, so daß eine weitere Kostenreduzierung möglich ist.

Bevorzugte Ausführungsbeispiele der vorliegenden Erfindung werden nachfolgend Bezug nehmend auf die beiliegenden Zeichnungen detailliert erläutert. Es zeigen:
- Fig. 1: ein Querschnitt durch ein Bauelement vor dem Zusammenfügen eines Systemwafers und eines Trägerwafers; und
- Fig. 2: einen Querschnitt durch das Bauelement nach dem Zusammenfügen des Systemwafers und des Trägerwafers und nach dem Lösen der Opferschicht.

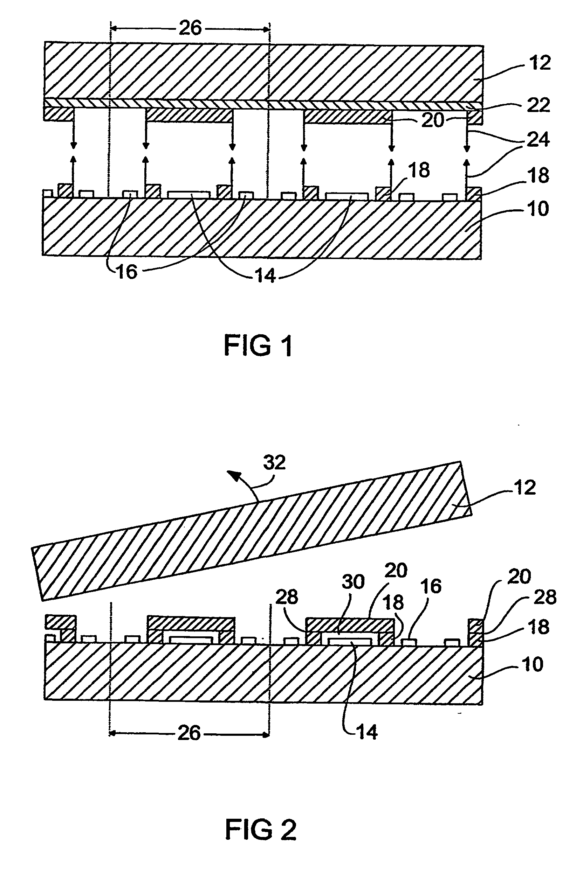

Fig. 1 zeigt einen Systemwafer 10 und einen Trägerwafer 12, wobei auf dem Systemwafer 10 Bauelemente angeordnet sind, die über Kontaktpads 16 kontaktierbar sind. Die Bauelemente 14 können entweder als diskrete Elemente auf dem Systemwafer 10 aufgebracht werden, beispielsweise durch Kleben, Flip-Chip-Montage etc., oder können in dem Systemwafer 10 integriert sein. Die Bauelemente sind beispielsweise BAW- oder SAW-Filter, Resonatoren, Sensoren oder Aktoren oder allgemein Bauelemente, die einen zu schützen Bereich 14 enthalten, d. h. der mit einer erfindungsgemäßen Abdeckung zu versehen ist. Um die Bauelemente 14 herum ist eine Rahmenstruktur 18 angeordnet, die je nach Anwendung entweder die Bauelemente vollständig umgibt, oder die Bauelemente beispielsweise in der Draufsicht nur an zwei Seiten umgibt. Die Rahmenstruktur 18 kann auch, wenn sie die Bauelemente vollständig umgibt, unterbrochen sein. Sie muß lediglich so ausgestaltet sein, daß sie eine Deckelstruktur 20 tragen kann. Wenn die Rahmenstruktur unterbrochen ist, schützt sie allerdings nicht gegen eine Vergußmasse, so daß falls Schutz gegen eine Vergußmasse gewünscht wird, eine ununterbrochene Rahmenstruktur bevorzugt wird.

Die Deckelstruktur 20 ist mittels einer.Opferschicht 22 an dem Trägerwafer 12 befestigt. Eine Abdeckung der aktiven Bereiche der Bauelemente 14 wird erreicht, indem der Trägerwafer 12 auf den Systemwafer gesetzt wird, und zwar in einer solchen Ausrichtung, wie sie durch Pfeile 24 dargestellt ist.

Es sei darauf hingewiesen, daß wie in der Halbleitertechnik üblich, eine Waferverarbeitung erfolgt, derart, daß eine Vielzahl von gleichartigen "Chips" auf einmal hergestellt wird, und daß dann, nach der Herstellung eine Vereinzelung stattfindet. Ein Chip ist durch gestrichelte Linien dargestellt und mit 26, bezeichnet. Im Sinne der vorliegenden Erfindung wird ein Chip 26, d. h. eine Anordnung mit zu schützendem Bauelement und darum gebildetem Rahmen samt Deckel, auch als gehäustes Bauelement bezeichnet.

Fig. 2 zeigt die integrierte Schaltung von Fig. 1, jedoch nach dem Aufsetzen des Trägerwafers 12 auf den Systemwafer, und zwar so, daß die Deckelstruktur 20 auf der Rahmenstruktur 18 aufsitzt. Damit die Deckelstruktur und die Rahmenstruktur aufeinander aufsitzen, wird es bevorzugt, die Rahmenstruktur und die Deckelstruktur durch einen Bondprozeß miteinander zu verbinden. Alternativ kann entweder auf die Rahmenstruktur oder auf die Deckelstruktur an den entsprechenden Stellen oder ganzflächig eine Kleberschicht 28 aufgebracht werden, die dazu dient, die Deckelstruktur 20 mit der Rahmenstruktur 18 als Verbindungsschicht mechanisch zu verbinden.

Aus Fig. 2 ist zu sehen, daß nach dem Aufsetzen des Trägerwafers und nach dem Lösen der Opferschicht 22 von Fig. 1 der Trägerwafer abgenommen werden kann, so daß die aktiven Bereiche der Bauelemente 14 in Hohlräumen 30 angeordnet sind, die sich ergeben, wenn der Deckel 20 auf den Rahmen 18 aufgesetzt wird. Eine abschließende Fertigung der Chips 26 zu einem gehäusten Bauelement, die in einem System eingesetzt werden kann, besteht darin, daß der Wafer an den punktierten Linien vereinzelt wird, so daß sich die einzelnen Chips 26 ergeben, daß dann der Chip 26 beispielsweise in einen Anschlußleitungsrahmen gelegt wird, um die Kontaktpads mit Bonddrähten nach außen zu führen, und daß dann der Chip mit kontaktiertem Anschlußleitungsrahmen in Kunststoff, Harz etc. vergossen wird, um eine fertiges Bauelement zu erhalten.

Die Abdeckung, die durch die Deckelstruktur 20 und die Rahmenstruktur 18 gebildet ist, hat den Vorteil, daß die Vergußmasse außerhalb des Hohlraums 30 gehalten wird, so daß das Bauelement 14 innerhalb des Hohlraums 30 nicht durch die Vergußmasse beeinträchtigt wird. Dies hat zum einen den Vorteil, daß keine mechanischen Teile gestört oder unbrauchbar gemacht werden, und daß auch die Umgebung z. B. eines BAW- oder SAW-Filters genau definiert ist, und zwar durch den Hohlraum 30 und die umgebende Abdeckung (Deckel 20 und Rahmen 18) aus einem bekannten Material, das hinsichtlich seiner Geometrie und Beschaffenheit vorbekannt ist und ohne weiteres reproduzierbar ist.

Bei einem ersten Ausführungsbeispiel zur Herstellung des Systemwafers werden die Bauelemente 14 in dem Systemwafer 10 prozessiert oder alternativ auf demselben aufgebracht. Anschließend wird mittels photolithographischer Verfahren die Rahmenstruktur 18 auf dem Systemwafer erstellt, und zwar so, daß Kontaktpads 16 zum Kontaktieren der Bauelemente 14 außerhalb der Rahmenstruktur sind, damit sie später noch kontaktiert werden können. Bei Flip-Chip Montage können die Kontaktpads mit einem eigenen Rahmen, als Inseln, auch innerhalb des Rahmens, der die aktive Fläche des Chips umgibt, angeordnet sein.

Als Material für die Rahmenstruktur 18 wird photostrukturierbares Epoxidharz, wie z. B. SU-8, benntzt. Je nach Höhe der aktiven Bereiche der Bauelemente 14 muß auch die Höhe der Rahmenstruktur 18, d. h. der Abstand der Oberkante der Rahmenstruktur 18 zu der Oberkante des Systemwafers 10 gewählt werden. Höhen größer als 5 µm für die Rahmenstruktur aus photostrukturierbarem Epoxidharz sind möglich.

Zur Herstellung des Trägerwafers wird zunächst ein "nackter" Trägerwafer 12 bereitgestellt. Dieser wird dann ganzflächig mit einer Opferschicht 22 bedeckt, um dann, auf der Opferschicht 22, die Deckelstruktur 20 zu erstellen. Die Deckelstruktur 20 besteht ebenfalls aus photostrukturierbarem Epoxidharz.

Die Dicke der Deckelstruktur 20 hängt von den zu überdeckenden Bereichen ab. Muß ein sehr großes Bauelement bedeckt werden, so wird die Deckelstruktur 20 dicker gewählt als wenn ein relativ schmales kleines Bauelement überdeckt werden muß. Die Dicke der Deckelstruktur beträgt bei einem bevorzugten Ausführungsbeispiel der vorliegenden Erfindung mehr als 5 µm.

Der Rahmen hat eine bevorzugte Dicke von ca. 5-15 µm, der Deckel von ca. 25-50 pm. Hierbei spielt das Verhältnis Dicke zu Spannweite eine wichtige Rolle und sollte >= 1:20 betragen. Typische Dicken sind 5-100 µm. Typische Spannweiten sind 50-1000 µm, bevorzugt 100-300 µm.

Die Strukturierung der Deckelstruktur 20 und der Rahmenstruktur 18 geschieht hinsichtlich des Systemwafers 10 und des Trägerwafers 12 ähnlich. Zunächst wird das Epoxidharz wie ein gewöhnlicher Photolack aufgeschleudert, belichtet und entwickelt. Im Gegensatz zum Photolack erreicht das Epoxidharz jedoch eine hohe und dauerhafte Härte, die es zumindest ermöglicht, daß die Abdeckung den Kräften widersteht, die auftreten, wenn der Chip vergossen wird. Wenn Rahmen und Deckel entsprechend stärker gewählt werden, kann ein abschließender Verguß der Schaltung auch entfallen. Dies wird jedoch von der einzelnen Anwendung abhängen.

Es sei darauf hingewiesen, daß die Deckelstruktur 20 so strukturiert ist, daß die Kontaktpads frei bleiben. Es ist nicht unbedingt erforderlich, daß die Kanten der Deckelstruktur annähernd bündig mit den Kanten der Rahmenstruktur sind, so lange die Kontaktpads für eine spätere Kontaktierung frei bleiben, und so lange sich ein Hohlraum 30 ergibt, der ausreichend widerstandsfähig gegenüber einem Eindringen der Vergußmasse oder Fremdstoffen ist. Soll das gehäuste Bauelement in einer aggressiven Umgebung angewendet werden, so kann das System aus Rahmen und Abdeckung selbstverständlich auch hermetisch dicht gemacht werden (z. B. durch Aufdampfen einer Metallschicht).

Die Verbindung der Deckelstruktur mit der Rahmenstruktur kann entweder mit Hilfe einer zusätzlichen Klebeschicht (28) erfolgen oder durch Bonden der Deckelstruktur auf die Rahmenstruktur. Wenn Deckel und Rahmen aus Epoxidharz hergestellt sind, so ergibt sich eine besonders einfache und kostengünstige Verbindung dadurch, daß Rahmen und/oder Deckel bei der Strukturierung nicht vollständig ausgehärtet (vernetzt) werden, und damit "klebrig" bleiben. Durch Zusammenfügen und vollständiges Vernetzen (unter Anpressdruck und erhöhter Temperatur oder photochemisch angeregt) wird dann eine feste Verbindung erzielt.

Ist eine feste Verbindung zwischen Rahmenstruktur 18 und Deckelstruktur 20 erreicht, so wird beim erfindungsgemäßen Verfahren die Opferschicht 22 gelöst, um dann, wie es in Fig. 2 durch einen Pfeil 32 dargestellt ist, den Trägerwafer abzunehmen.

Alternativ zu der separaten Strukturierung des Trägerwafers 12 bzw. der Deckelstruktur 20 auf dem Trägerwafer 12 kann auch ein Trägerwafer 12 mit Opferschicht 22 und vollflächiger Deckelschicht 20 verwendet werden und auf die Rahmenstrukturen 18 des Systemwafers aufgesetzt und mit derselben verbunden werden, um dann zunächst die Opferschicht zu lösen, und um dann den Trägerwafer abzunehmen. Hierauf hat dann eine Strukturierung der Deckelstruktur stattzufinden, dahingehend, daß diese in den Bereichen, wo die Kontaktpads 16 sind, entfernt wird, wie z. B. durch Photostrukturierungstechniken.

In beiden Alternativen kann der Trägerwafer 12 erneut zur Erfüllung derselben Funktion verwendet werden. Dies führt zu einer Kosteneinsparung, die auch darauf zurückzuführen ist, daß auf billiges Epoxidharz gegenüber teueren Silizium- oder Quarzwafern zurückgegriffen werden kann. Aufgrund genauerer Strukturierbarkeit und geringerer Vorhaltemaße in Verbindung mit einem geeigneten Bondprozeß wird bei der Verbindung von Epoxidharz zu Epoxidharz eine geringere Bondfläche im Vergleich zu einer Silizium-Silizium oder Silizium-Glas-Bondverbindung benötigt. Dies führt dazu, daß Schaltungen dichter auf einem Wafer angeordnet werden können, so daß auch die Schaltungsausbeute pro vorgegebener Wafergröße erhöht werden kann.

Der abschließende Aufbau der Chips, um ein gehäustes Bauelement zu erhalten, kann dann, wie es ausgeführt worden ist, in einem Standard-Kunststoff-Gehäuse erfolgen.

Die vorliegende Erfindung ist dahingehend vorteilhaft, daß photostrukturierbares Epoxidharz zur Erzeugung eines Hohlraums über empfindlichen Bauelementen verwendet wird, wobei dieses zunächst auf zwei verschiedenen Wafern, d. h. dem Systemwafer und dem Trägerwafer, aufgebracht wird, um dann beide Wafer an der Oberkante der Rahmenstruktur 18 und der Unterkante der Deckelstruktur 20 miteinander zu verbinden, um dann nach Lösen der Opferschicht 22 den Trägerwafer wieder zu entfernen und für die Erzeugung einer weiteren Abdeckstruktur wiederzuverwenden.

Als Material für die Opferschicht können beliebige Materialien verwendet werden. Für die vorliegende Erfindung wird es bevorzugt, eine auflösbare oder ätzbare Opferschicht zu nehmen, die so lösbar oder ätzbar ist, daß der Trägerwafer 12 selbst und die Deckelstruktur 20 nach dem Aufbringen auf die Rahmenstruktur (Fig. 2) nicht oder nur unwesentlich beim Auflösen/Ätzen der Opferschicht beeinträchtigt werden. Beispiele für Materialien sind andere Kunststoffe als für Rahmen und Deckel, andere Lacke, Wachs, oder Metalle, Dielektrika etc. Die einzige Forderung ist eine chemische Selektivität hinsichtlich Lösbarkeit/Ätzbarkeit zum Deckel- und Rahmenmaterial sowie der oberen Schicht.

Ein weiterer Vorteil der vorliegenden Erfindung besteht darin, daß das Packaging, d. h. das Erzeugen der Abdeckung für die sensiblen Bauelemente 14 bereits auf Waferebene stattfindet und nicht an einzelnen Bauelementen sequenziell.

### Bezugszeichenliste

- 10: Systemwafer
- 12: Trägerwafer
- 14: Bauelemente
- 16: Kontaktpads
- 18: Rahmenstruktur
- 20: Deckelstruktur
- 22: Opferschicht
- 24: Ausrichtungspfeile
- 26: vereinzelte Schaltung
- 28: Verbindungsschicht
- 30: Bereich unter der Abdeckung
- 32: Wegbewegung des Trägerwafers

## Patentansprüche

1. Verfahren zum Erzeugen von Abdeckungen für eine Mehrzahl von Bereichen (30) auf einem Systemwafer (10), wobei jeder Bereich (30) ein Bauelement (14) aufweist, wobei außerhalb jedes Bereichs (30) Kontaktanschlußflächen (16) für die Bauelemente (14) vorgesehen sind, mit folgenden Schritten:
Bereitstellen des Systemwafers (10) mit den Bauelementen (14);
Erzeugen einer Rahmenstruktur (18) für jeden Bereich (30) des Systemwafers (10), wobei der Schritt des Erzeugens ferner folgende Unterschritte aufweist:
Aufschleudern eines photostrukturierbaren Epoxidharzmaterials auf den Systemwafer (10);
Belichten des photostrukturierbaren Epoxidharzmaterials;
Entwickeln des photostrukturierbaren Epoxidharzmaterials; und
Entfernen des durch die Belichtung definierten Epoxidharzmaterials, um die Rahmenstruktur (18) für jeden Bereich des Systemwafers (10) zu erhalten;
Bereitstellen eines Trägerwafers (12), wobei der Trägerwafer (12) eine Opferschicht (22) aufweist,
Erzeugen einer Deckelstruktur (20) zum Anbringen auf der Rahmenstruktur (18), so daß der Bereich zwischen der Deckelstruktur (20) und dem Systemwafer (10) abgedeckt ist, wobei der Schritt des Erzeugens ferner folgende Unterschritte aufweist:
Aufschleudern eines photostrukturierbaren Epoxidharzmaterials auf die Opferschicht (22) auf dem Trägerwafer (12);
Strukturieren des photostrukturierbaren Epoxidharzmaterials, um die Deckelstruktur (20) zu erzeugen; und
Verbinden der Deckelstruktur (20) mit der Rahmenstruktur (18); und
Entfernen der Opferschicht (22) von dem Trägerwafer (12), um die Deckelstruktur (20) von dem Trägerwafer (12) zu trennen,
wobei der Unterschritt des Strukturierens im Schritt des Erzeugens der Deckelstruktur (18) vor dem Schritt des Entfernens der Opferschicht (22) oder nach dem Schritt des Entfernens der Opferschicht (22) stattfindet.

2. Verfahren nach Anspruch 1,
bei dem der Schritt des Verbindens ein Bonden und/oder Verkleben (28) der Deckelstruktur (20) und der Rahmenstruktur (18) aufweist.

3. Verfahren nach Anspruch 1 oder 2,
bei dem das Bauelement (14) ein elektromechanisches und/oder mikromechanisches Element aufweist.

4. Verfahren nach einem der Ansprüche 1 bis 3,
bei dem das photostrukturierbare Epoxidharzmaterial für die Rahmenstruktur (18) und für die Deckelstruktur (20) gleiche Materialien sind.

5. Verfahren nach einem der vorhergehenden Ansprüche,
bei dem das photostrukturierbare Epoxidharzmaterial der Rahmenstruktur (18) und/oder der Deckelstruktur (20) Epoxidharz vom Typ SU-8 ist.

6. Verfahren nach einem der vorhergehenden Ansprüche,
bei dem die Rahmenstruktur (18) eine Höhe von mehr als 5 µm aufweist, und/oder
bei dem die Deckelstruktur (20) eine Höhe von mehr als 5 µm aufweist.

7. Verfahren nach einem der vorhergehenden Ansprüche, ferner mit folgendem Schritt:
Anordnen eines Vergußmaterials um die Rahmenstruktur (18) herum, jedoch nicht innerhalb der Rahmenstruktur (18).

## Claims

1. A method for producing covers for a plurality of regions (30) on a system wafer (10), each region (30) comprising a device (14), wherein contact pads (16) for the devices (14) are provided outside each region (30), comprising:
providing the system wafer (10) having the devices (14);
producing a frame structure (18) for each region (30) of the system wafer (10), wherein the step of producing further comprises the following substeps:
spinning a photostructurable epoxy resin material onto the system wafer (10);
exposing the photostructurable epoxy resin material;
developing the photostructurable epoxy resin material; and
removing the epoxy resin material defined by the exposure to obtain the frame structure (18) for each region of the system wafer (10);
providing a support wafer (12), wherein the support wafer (12) comprises a sacrificial layer (22),
producing a cap structure (20) for attaching it to the frame structure (18) so that the region between the cap structure (20) and the system wafer (10) is covered, wherein the step of producing further comprises the following substeps:
spinning a photostructurable epoxy resin material onto the sacrificial layer (22) on the support wafer (12);
structuring the photostructurable epoxy resin material to produce the cap structure (20); and
connecting the cap structure (20) to the frame structure (18); and
removing the sacrificial layer (22) from the support wafer (12) to separate the cap structure (20) from the support wafer (12),
wherein the substep of structuring occurs in the step of producing the cap structure (18) prior to the step of removing the sacrificial layer (22) or after the step of removing the sacrificial layer (22).

2. The method of claim 1,
wherein the step of connecting comprises bonding and/or adhering (28) the cap structure (20) and the frame structure (18).

3. The method of claim 1 or 2,
wherein the device (14) comprises an electromechanical and/or micromechanical element.

4. The method of one of claims 1 to 3,
wherein the photostructurable epoxy resin material for the frame structure (18) and for the cap structure (20) are the same materials.

5. The method of one of the preceding claims,
wherein the photostructurable epoxy resin material of the frame structure (18) and/or the cap structure (20) is epoxy resin of the type SU-8.

6. The method of one of the preceding claims,
wherein the frame structure (18) has a height of more than 5 µm, and/or
wherein the cap structure (20) has a height of more than 5 µm.

7. The method of one of the preceding claims, further comprising:
arranging a casting material around the frame structure (18), but not within the frame structure (18).

## Revendications

1. Procédé de production de couvertures pour une multiplicité de zones (33) sur une tranche (10) de système, chaque zone (30) ayant un composant (14), en prévoyant des surfaces (16) de borne de contact pour les composants (14) à l'extérieur de chaque zone (30), comprenant les stades suivants :
mise à disposition de la tranche (10) de système ayant les composants (14) ;
production d'une structure (18) de cadre pour chaque zone (30) de la tranche (10) de système, le stade de la production comprenant, en outre, les sous-stades suivants :
dépôt par centrifugation d'une matière en résine époxyde pouvant être photostructurée sur la tranche (10) de système ;
exposition de la matière en résine époxyde qui peut être photostructurée ;
dévelopement de la matière de résine époxyde qui peut être photostructurée ; et
élimination de la matière de résine époxyde définie par l'exposition pour obtenir la structure (18) de cadre pour chaque zone de la tranche (10) de système ;
mise à disposition d'une tranche (12) support, la tranche (12) support ayant une couche (22) sacrificielle,
production d'une structure (20) de couvercle à mettre sur la structure (18) de cadre, de manière à recouvrir la zone comprise entre la structure (20) de couvercle et la tranche (10) de système, le stade de la production comprenant, en outre, les sous-stades suivants :
dépôt par centrifugation d'une matière de résine époxyde pouvant être photostructurée sur la couche (22) sacrificielle sur la tranche (12) de support ;
structuration de la matière de résine époxyde pouvant être
photostructurée pour produire la structure (20) de couvercle ; et
liaison de la structure (20) de couvercle à la structure (18) de cadre; et
élimination de la couche (22) sacrificielle de la tranche (12) de support pour séparer la structure (20) de couvercle de la tranche (12) de support,
dans lequel le sous-stade de la structuration au stade de la production de la structure (18) de couvercle a lieu avant le stade de l'élimination de la couche (22) sacrificielle ou après le stade de l'élimination de la couche (22) sacrificielle.

2. Procédé suivant la revendication 1,
dans lequel le stade de la liaison comporte un soudage et/ou un collage (28) de la structure (20) de couvercle et de la structure (18) de cadre.

3. Procédé suivant la revendication 1 ou 2,
dans lequel le composant (14) a un élément électromécanique et/ou micromécanique.

4. Procédé suivant l'une des revendications 1 à 3,
dans lequel les matières de résine époxyde qui peuvent être photostructurées pour la structure (18) de cadre et pour la structure (20) de couvercle sont les mêmes.

5. Procédé suivant l'une des revendications précédentes,
dans lequel la matière de résine époxyde qui peut être photostructurée de la structure (18) de cadre et/ou de la structure (20) de couvercle est une résine époxyde du type SU-8.

6. Procédé suivant l'une des revendications précédentes,
dans lequel la structure (18) de cadre a une hauteur de plus de 5 µm, et/ou dans lequel la structure (20) de couvercle a une hauteur de plus de 5 µm.

7. Procédé suivant l'une des revendications précédentes, comprenant, en outre, le stade suivant :
mise d'une matière de scellement autour de la structure (18) de cadre mais non à l'intérieur de la structure (18) de cadre.
